# EUROPÄISCHE PATENTSCHRIFT

(11) **EP 0 518 847 B1**
(45) Veröffentlichungstag und Bekanntmachung des Hinweises auf die Patenterteilung: **27.12.1996**
(21) Anmeldenummer: 92890130.5
(22) Anmeldetag: 27.05.1992
(51) Int. Cl.: H03K 19/08, H03K 19/003, H03K 19/0944

(54) **Integrierte Schaltungsanordnung mit Junction-, MOS- und Bipolar-Transistoren**
Integrated circuit arrangement having junction-, MOS- and bipolar transistors
Circuit intégré comportant des transistors bipolaires, MOS et à jonction

(30) Priorität: 28.05.1991 AT 1082/91
(43) Veröffentlichungstag der Anmeldung: 16.12.1992
(73) Patentinhaber: AUSTRIA MIKRO SYSTEME INTERNATIONAL AKTIENGESELLSCHAFT, A-8141 Unterpremstätten (AT)
(72) Erfinder: Armgarth, Dietrich, Dipl. Ing. Dr., O-8060 Dresden (DE)
(74) Vertreter: Haffner, Thomas M., Dr.

(56) Entgegenhaltungen:
- EP-A- 0 403 075
- DD-A- 225 286
- IBM TECHNICAL DISCLOSURE BULLETIN Band 34, Nr. 4A, September 1991, Seiten 96-98; "BiCMOS Logic Circuits using Emulated-PNP Transistor"
- IEEEE JOURNAL OF SOLID-STATE CIRCUITS Band 26, Nr. 4, April 1991, Seiten 578-584, New York, US; H.J. SHIN: "Full-Swing BiCMOS Logic Circuits with Complementary Emitter-Follower Driver Configuration"
- IBM TECHNICAL DISCLOSURE BULLETIN Band 32, Nr. 10A, März 1990, Seiten 34-36; "Full-Swing Fully-Complementary MOS/Bipolar Logic Circuits"

## Beschreibung

Die Erfindung betrifft eine integrierte Schaltungsanordnung mit Junction-, MOS- und Bipolar-Transistoren zur Realisierung von logischen Funktionen, mit komplementären MOS-Transistoren, die vom Eingang gesteuert werden, und einer Reihenschaltung eines ersten und eines zweiten Bipolar-Transistors, die einen Ausgang steuert, wobei ein n-Kanal-MOS-Transistor zwischen dem Kollektor und der Basis des ersten Bipolar-Transistors und ein p-Kanal-MOS-Transistor zwischen dem Kollektor und der Basis des zweiten Bipolar-Transistors angeordnet sind.

Integrierte Schaltungsanordnungen mit MOS- und Bipolar-Transistoren sind aus der Literatur bekannt.

Typisch für diese Schaltungsanordnungen, wie z. B. nach der EP-OS 145 004, in welcher MOS-Transistoren auf der Eingangsseite und Bi.polar-Transistoren auf der Ausgangsseite angegeben sind, ist, daß der L-Pegel um etwa 0,5 V angehoben und der H-Pegel um etwa den gleichen Betrag abgesenkt wird. Bei der Zusammenschaltung mit reinen CMOS-Schaltungsanordnungen können daher Probleme derart auftreten, daß die CMOS-Transistoren nicht mehr sicher gesperrt werden. Außerdem treten große Werte für die Gatterlaufzeiten auf, wenn solche Schaltungsanordnungen bei Betriebsspannungswerten von 2 ... 3 V betrieben werden sollen. Da die Werte für die Basis-Emitterflußspannung UBE des Bipolar-Transistors und für die Schwellspannung UTH des MOS-Transistors etwa konstant bleiben, verringern sich die Steuerspannungswerte (UGS-UTH) drastisch. UGS ist die angelegte Spannung zwischen Gate und Source.

In der US-PS 4159 450 werden ebenfalls MOS-Transistoren auf der Eingangsseite und Bipolar-Transistoren auf der Ausgangsseite verwendet, wobei hier komplementäre Bipolar-Transistoren zur Anwendung kommen. Auch diese Schaltungsanordnung weist die oben angegebenen Nachteile auf. Da hier zwischen dem Ausgang und Masse ein pnp-Transistor verwendet wird, ist diese Schaltungsanordnung außerdem für hohe Frequenzen ungeeignet.

Mit der EP-OS 110 113 liegt eine Schaltungsanordnung vor, die etwa der in der EP-OS 145 004 entspricht. Hier wird nur der n-Kanal-MOS-Transistor, der zur Entladung der Basis des oberen Bipolar-Transistors verwendet wird, zwischen Basis und Emitter angeordnet. Ansonsten treten die gleichen Nachteile wie bei der Schaltung nach der EP-OS 145 004 auf.

In der EP-OS 134 731 wird eine Schaltungsanordnung angegeben, die als oberen Bipolar-Transistor einen pnp-Transistor vorsieht. Es treten die eingangs erwähnten Nachteile ebenfalls auf, d. h. kein voller Spannungshub am Ausgang und für hohe Frequenzen nur bedingt geeignet.

Die Schaltungsanordnung gemäß der EP-OS 225 489 ist ähnlich der aus der EP-OS 145 004. Zur Entladung der Basis des unteren Transistors wird-hier an Stelle des sonst üblichen Transistors ein Widerstand verwendet.

In der DD-PS 225 286 wurden Schaltungsanordnungen mit MOS- und Bipolar-Transistoren angegeben, die diese Nachteile beseitigen, die aber andererseits einen hohen Aufwand an Transistoren erfordern, wenn integrierte Schaltungsanordnungen mit mehreren Eingängen aufgebaut werden müssen. Als nachteilig ist der stationäre Stromfluß zu betrachten, wenn am Eingang der H-Pegel anliegt. Diese Schaltungsanordnungen sind daher zur Realisierung von logischen Funktionen in hochintegrierten Schaltkreisen nur bedingt geeignet. Der unabhängige Anspruch ist gegenüber diesem Stand der Technik abgegrenzt.

In der DD-PS 270 410 wurde eine integrierte Schaltungsanordnung mit MOS-Transistoren auf der Eingangsseite und Bipolar-Transistoren auf der Ausgangsseite, wobei die Bipolar-Transistoren in Reihe zwischen Betriebsspannung und Masse geschaltet sind und zwischen ihnen ein Ausgang herausgeführt ist, vorgeschlagen, bei der parallel zu den ausgangsseitigen Bipolar-Transistoren n-Kanal-Sperrschichtfeldeffekt-Transistoren vorgesehen sind.

Diese Schaltungsanordnung hat jedoch den Nachteil, daß die Sperrschichtfeldeffekt-Transistoren nicht vollständig gesperrt werden, so daß im stationären Zustand ein Ruhestrom fließt, der den Schaltkreis und die Stromquelle unnötigerweise belastet.

Bei allen diesen Schaltungsanordnungen sind MOS-Transistoren bzw. Widerstände erforderlich, um den oberen Bipolar-Transistor sicher zu sperren. Werden n-Kanal-MOS-Transistoren verwendet, so muß das Gate auf den Eingang geführt werden. Das bedeutet bei mehreren Eingängen, daß pro Eingang ein Transistor mehr vorhanden sein muß. Wird ein Widerstand zwischen Basis und Emitter beim oberen Bipolar-Transistor vorgesehen, so geht ein Teil des Basissteuerstromes verloren und der entsprechende p-Kanal-Transistor muß vergrößert werden. Das bedeutet wieder mehr Platz und eine Schaltzeitvergrößerung.

In der EP-OS 279 332 wird eine Schaltungsanordnung vorgestellt, die etwa wie die in der EP-OS 145 004 aufgebaut ist. Zusätzlich wird hier ein weiterer CMOS-Inverter zum Ausgang parallelgeschaltet. Gesteuert wird dieser CMOS-Inverter vom Eingang. Der Ausgangspegel wird hier zwar nach Betriebsspannung bzw. nach Masse gezogen, jedoch ist der Aufwand an Transistoren und damit an Chipfläche gestiegen, besonders dann, wenn mehrere Eingänge vorhanden sind.

Auch in der EP-OS 212 004 wird ein CMOS-Inverter parallel zum Ausgang vorgesehen. Dieser Inverter verwendet nur weitere Bauelemente für seine Aussteuerung vom Eingang her und ist damit noch aufwendiger geworden.

Die Schaltungsanordnung gemäß der EP-OS 441 317 verwendet auch wieder einen CMOS-Inverter parallel zum Ausgang, um den Ausgangspegel auf VDD bzw. nach Masse zu ziehen. Im Grundaufbau wird hier nur als unterer Bipolar-Transistor ein pnp-Transistor verwendet.

Auch bei dieser Schaltungsanordnung ist der Aufwand an Bauelementen und damit an Chipfläche groß. Außerdem ist durch Verwendung des pnp-Transistors die Schaltungsanordnung gegenüber den anderen bekannten dynamisch ungünstiger.

Das Ziel der Erfindung ist es, eine integrierte Schaltungsanordnung zu schaffen, die mit Junction-, MOS- und Bipolar-Transistoren aufgebaut ist, die den vollen Signalhub am Ausgang zur Verfügung stellt, die pro Eingang nur zwei MOS-Transistoren benötigt und die gewährleistet, daß die Bipolar-Transistoren sicher gesperrt werden.

Diese Aufgabe wird durch die Merkmale des Anspruchs 1 gelöst.

Bestünde eine Schaltungsanordnung dieser Art lediglich aus zwei komplementären MOS-Enhancement-Transistoren als Eingangsstufen und zwei Bipolar-Transistoren vom gleichen Leitungstyp als Ausgangsstufen, dann wäre bei L-Pegel am Eingang die Basis des zweiten Bipolar-Transistors (npn) über die leitende Source-Drain-Strecke des p-Kanal-MOS-Transistors niederohmig an Betriebsspannung gelegt und der zweite Bipolar-Transistor somit leitend. Die Basis des ersten Bipolar-Transistors erhält zwar über den gesperrten n-Kanal-MOS-Transistor keinen Strom, jedoch kann dieser Bipolar-Transistor einen unbestimmten Leckstrom führen. Nach der Erfindung werden in dieser Hinsicht durch den zweiten n-Kanal-MOS-Transistor eindeutige Verhältnisse geschaffen, indem dieser bei L-Pegel am Eingang die Basis-Emitter-Strecke des ersten Bipolar-Transistors niederohmig überbrückt. Beim Umschalten des Einganges von L-Pegel auf H-Pegel wird der n-Kanal-MOS-Transistor leitend und der p-Kanal-MOS-Transistor fast vollständig gesperrt. Dadurch sinkt das Potential am Ausgang sowie an der Basis des zweiten Bipolar-Transistors auf einen kleinen Wert, wobei einerseits der zweite n-Kanal-MOS-Transistor gesperrt wird und andererseits die mit diesem in Reihe liegende, den p-Kanal-MOS-Depletion-Transistör und den n-Kanal-JFET umfassende Reihenschaltung leitend wird. Dabei beträgt die Spannung zwischen unbelastetem Ausgang und Masse 0,2 bis 0,3 V. Durch die erfindungsgemäßen Maßnahmen ist somit am Ausgang ein großer Spannungshub erzielbar, wobei bei unbelastetem Ausgang die Schaltungsanordnung in beiden stationären Binärzuständen stromlos ist.

Eine Verbesserung des dynamischen Verhaltens der Schaltungsanordnung läßt sich erzielen, wenn zwischen der Betriebsspannung und dem Drain des p-Kanal-MOS-Transistors und/oder zwischen der Betriebsspannung und dem Ausgang und/oder zwischen dem Ausgang und Masse ein Zweipol, bestehend aus einer Reihenschaltung eines n-Kanal-JFET und eines p-Kanal-MOS -Depletion-Transistors, wobei das Gate des n-Kanal-JFET mit dem Drain des p-Kanal-MOS-Depletion-Transistors und das Gate des p-Kanal-MOS-Depletion-Transistors mit dem Drain des n-Kanal-JFET zusammengeschaltet sind, angeordnet ist. Ein derartiger iweipol, der bei einer anliegenden Spannung von weniger als 1 V einen kleinen Widerstand und bei zunehmender Spannung einen rasch anwachsenden Widerstand aufweist, sorgt beispielsweise bei einem Umschaltvorgang im Sinne des Leitendmachens des zweiten Bipolar-Transistors für eine vorübergehende Erhöhung seines Basisstromes, so daß die parasitäre Kapazität am Ausgang schneller aufgeladen wird. Ein zwischen Betriebsspannung und Ausgang angeordneter Zweipol derselben Art sorgt dafür, daß die Spannung am Ausgang im H-Zustand auf das Potential der Betriebsspannung gezogen wird. Im entsprechenden Sinne wirkt ein Zweipol derselben Art zwischen dem Ausgang und Masse als Unterstützung für den ersten Bipolar-Transistor.

Eine Weiterbildung der erfindungsgemäßen Schaltungsanordnung besteht darin, daß ein weiterer Steuereingang vorgesehen ist, daß der Steuereingang auf einen Negator und auf das Gate eines dritten n-Kanal-MOS-Transistors geführt ist, daß der Ausgang des Negators auf Gates von vierten und fünften n-Kanal-MOS-Transistoren und auf das Gate eines weiteren p-Kanal-MOS-Transistors geführt ist, daß die Source-Drainstrecke des vierten n-Kanal-MOS-Transistors zwischen der Basis des ersten Bipolar-Transistors und Masse angeordnet ist, daß die Source-Drain-strecke des dritten n-Kanal-MOS-Transistors zwischen dem Ausgang und dem Drain des n-Kanal-JFET angeordnet ist, daß die Source-Drainstrecke des fünften n-Kanal-MOS-Transistors zwischen der Basis des zweiten Bipolar-Transistors und Masse angeordnet ist und daß die Source-Drainstrecke des weiteren p-Kanal-MOS-Transistors zwischen der Basis des zweiten Bipolar-Transistors und dem Drain des p-Kanal-MOS-Transistors vorgesehen ist. Durch diese Ergänzung ist die Möglichkeit geboten, die beiden gleichstrommäßig in Reihe geschalteten Bipolar-Transistoren, an deren Verbindungsstelle der Ausgang liegt, und den dritten n-Kanal-MOS-Transistor, dessen Source-Drain-Strecke ebenfalls am Ausgang angeschlossen ist, gleichzeitig nichtleitend zu machen, so daß man eine Schaltungsanordnung mit sogenannter TRISTATE-Ausgangscharakteristik erhält, wobei der Ausgang im Betrieb der Schaltungsanordnung L-Pegel oder H-Pegel aufweisen kann oder ohne Zerstörung der Schaltungsanordnung von der Ausgangsseite her beliebig auf L-Pegel oder H-Pegel gebracht werden kann. Dies ermöglicht bei Bedarf eine direkte galvanische Verbindung der Ausgänge mehrerer Schaltungsanordnungen ohne gegenseitige Störung ihrer Funktionen und ohne Gefahr einer Beschädigung der Schaltungsanordnungen.

Eingangsmäßige Erweiterungen der Schaltungsanordnung sind im Rahmen der Erfindung dadurch möglich, daß zur Realisierung von NAND-Schaltungen weitere n-Kanal-MOS-Transistoren in Reihe zum n-Kanal-MOS-Transistor und weitere p-Kanal-MOS-Transistoren parallel zum p-Kanal-MOS-Transistor angeordnet sind oder daß zur Realisierung von NOR-Schaltungen'weitere n-Kanal-MOS-Transistor parallel zum n-Kanal-MOS-Transistor und weitere p-Kanal-MOS-Transistoren in Reihe zum p-Kanal-MOS-Transistor angeordnet sind.

Um die Anzahl der Arbeitsschritte bei der Herstellung der integrierten Schaltungsanordnung gering zu halten, können die Zweipole mit bereichsweise fallender Strom-Spannungs-charakteristik und der zweite Bipolar-Transistor in einem isolierten Gebiet untergebracht werden bzw. können der Zweipol mit bereichweise fallender Strom-Spannungscharakteristik, der als Junction-Transistor ausgebildete n-Kanal-FET und der erste Bipolar-Transistor in einem isolierten Gebiet untergebracht werden. Da das isolierte Gebiet des zweiten Bipolar-Transistors an der Betriebsspannung liegt, wird das dynamische Verhalten durch die größere Kapazität nicht beeinträchtigt.

Die Erfindung wird nachfolgend an Hand von in der Zeichnung dargestellten Ausführungsbeispielen näher erläutert. Es zeigen
Fig.1 eine erfindungsgemäße integrierte Schaltungsanordnung;

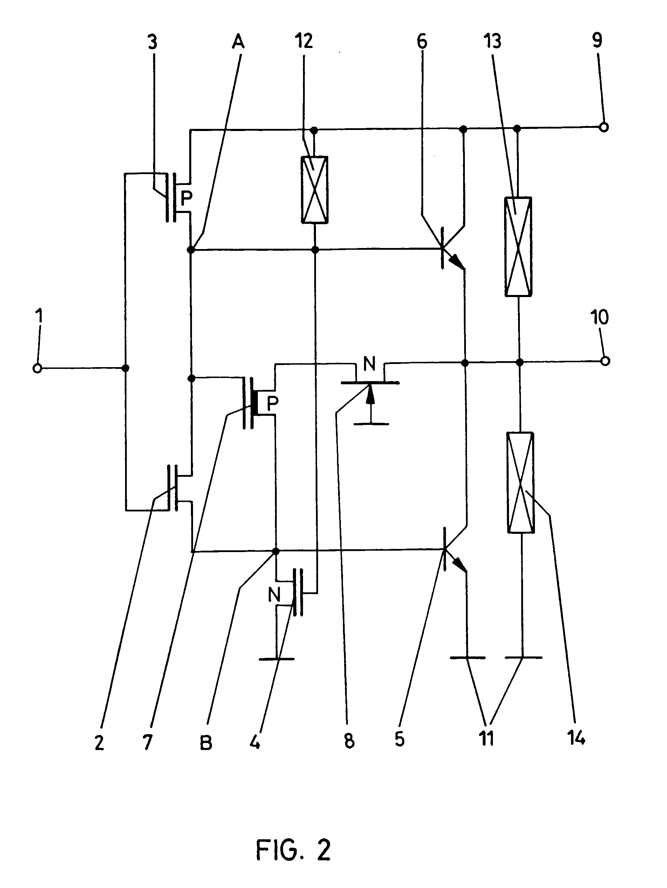

Fig.2 eine Erweiterung der erfindungsgemäßen integrierten Schaltungsanordnung; Fig.3 eine integrierte Schaltungsanordnung nach Fig.1 mit einer TRISTATE-Steuermöglichkeit.

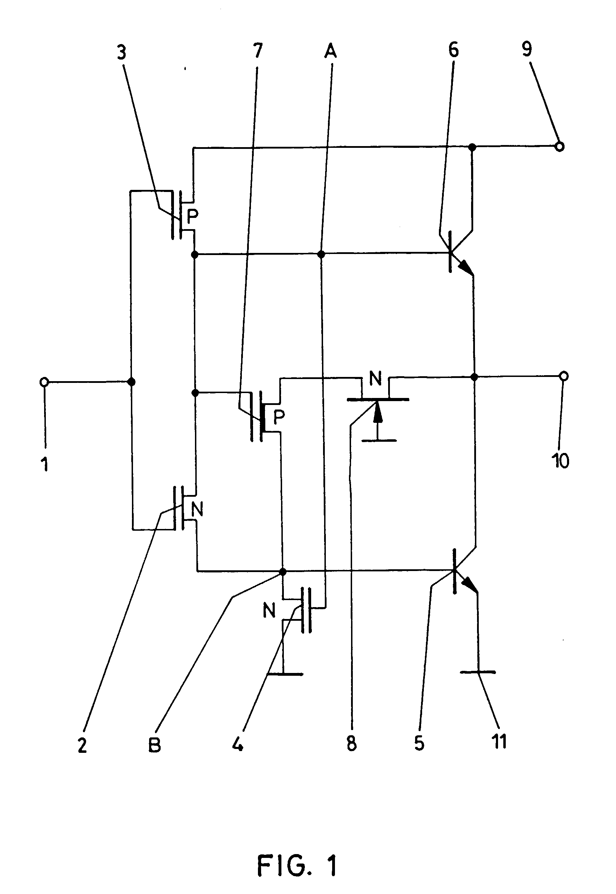

Gemäß Fig.1 ist ein Eingang 1 auf die Gates von n- und p-Kanal-MOS-Enhancement-Transistoren 2, 3 geführt. Das Source des n-Kanal-Transistors 2 ist mit der Basis des Bipolar-Transistors 5 verbunden. Das Drain dieses Transistors ist mit dem Drain des p-Kanal-Transistors 3, dem Gate des p-Kanal-MOS-Depletion-Transistors 7 und der Basis des Bipolar-Transistors 6 zusammengeschaltet. Das Source des p-Kanal-Transistors 3 und der Kollektor des Bipolar-Transistors 5 sind mit dem Ausgang 10 zusammengeschaltet. Das Drain des n-Kanal-MOS-Transistors 4 ist mit der Basis des Bipolar-Transistors 5 verbunden, während das Source des n-Kanal-Transistors 4 und der Emitter des Bipolar-Transistors 5 mit Masse 11 zusammengeschaltet sind. Weiterhin ist zwischen dem Ausgang 10 und der Basis des Bipolar-Transistors 5 eine Reihenschaltung der Source-Drain-Strecken eines n-Kanal-JFET 8 und eines p-Kanal-MOS-Depletion-Transistors 7 angeordnet. Das Gate des n-Kanal-JFET 8 ist dabei an Masse 11 angeschaltet und kann je nach Realisierungsvariante wahlweise auch mit dem Drain des p-Kanal-MOS-Depletion-Transistors 7 verbunden sein.

Das Gate des p-Kanal-MOS-Depletion-Transistors 7 ist dagegen immer mit dem Drain des n-Kanal-MOS-Transistors 2 zusammengeschaltet.

Dynamisch wirkt die Schaltungsanordnung gemäß Fig.1 wie ein Negator. Liegt am Eingang 1 L-Pegel an, so ist der n-Kanal-MOS-Transistor 2 gesperrt und der p-Kanal-MOS-Transistor 3 leitend. Der Knotenpunkt A weist damit ein Potential auf, das etwa dem der Betriebsspannung entspricht. Dadurch ist nun aber auch der n-Kanal-MOS-Transistor 4 leitend und schließt die Basis-Emitter-Strecke des Bipolar-Transistors 5 kurz, so daß auch dieser Transistor 5 sicher gesperrt ist. Am Ausgang 10 pegelt sich ein Spannungswert ein, der etwa so groß ist wie die Betriebsspannung minus der UBE-Spannung des Bipolar-Transistors 6, also bei UDD = 5 V wird UOH ∼ 4,5 V. Bei diesen Spannungsverhältnissen ist die Reihenschaltung aus MOS-Depletion-Transistor 7 und JFET 8 gesperrt. Es fließt kein Strom vom Ausgang 10 zum Knotenpunkt B und damit überhaupt kein stationärer Strom in der Schaltung. Die parasitäre Kapazität am Ausgang 10 ist somit auf etwa 4,5 V aufgeladen.

Wird der Eingang 1 von L nach H umgeschaltet, so wird zunächst der n-Kanal-MOS-Transistor 2 leitend. Der p-Kanal-MOS-Transistor 3 wird dagegen nur weniger leitend, wenn bei UDD = 5 V die Eingangsspannung einen Wert von etwa 3 V erreicht hat. Das Potential am Knotenpunkt A sinkt ab. Der Strom vom n-Kanal-MOS -Transistor 2 kann nun nicht mehr durch den n-Kanal-MOS-Transistor 4 nach Masse 11 abgeleitet werden, sondern fließt in die Basis des Bipolar-Transistors 5. Dadurch wird das Potential am Ausgang 10 abgesenkt und damit auch weiter das am Knotenpunkt A. Bei einer Eingangsspannung von etwa 4,5 V ist dann der p-Kanal-MOS-Transistor 3 fast vollständig gesperrt. Der n-Kanal-MOS-Transistor 2 ist nun vollständig leitend und steuert den Bipolar-Transistor 5 vollständig durch. Die parasitäre Kapaziät am Ausgang 10 ist nach kurzer Zeit völlig entladen, und der Ausgäng 10 weist ein UOL ∼ 0,2 ... 0,3 V je nach parasitarer Kapazität auf. Bei diesen Spannungsverhältnissen ist die Reihenschaltung aus JFET 8 und MOS-Depletion-Transistor 7 niederohmig geworden. Durch den n-Kanal-MOS -Transistor 2 ist die Gate-Drain-Strecke des p-Kanal-MOS-Depletion -Transistors 7 kurzgeschlossen worden und damit ist die Reihenschaltung in den niederohmigen Zustand gebracht worden. Das Potential am Knotenpunkt A ist damit gleich dem Potential am Ausgang 10. Das entspricht aber einem Kurzschluß der Basis-Emitter-Strecke des Bipolar-Transistors 6. Damit ist dieser Transistor bis zu höchsten Temperaturen sicher gesperrt und ein gegebenenfalls auftretender Sperrstrom durch den p-Kanal-MOS-Transistor 3 wird am Bipolar-Transistor 6 "vorbeigeleitet" und kann nicht verstärkt werden.

Auch in diesem stationären Zustand fließt kein Ruhestrom durch die Schaltungsanordnung.

Der Vorteil gegenüber allen bisher bekannten BICMOS-Schaltungsanordnungen liegt darin, daß ein Eingang nur mit zwei Gates kapazitiv belastet ist, daß keine hochohmigen Widerstände zwischen Basis und Emitter bei den Bipolar-Transistoren vorhanden sind, die das dynamische Verhalten ungünstig beeinflussen, und daß die Basis-Emitter-Strecke des Bipolar-Transistors 6 im Ausgangs-L-Zustand durch die Transistoren 2, 7, 8 kurzgeschlossen ist.

In einer weiteren Variante besteht die Möglichkeit, zwischen der Betriebsspannung 9 und dem Drain des p-Kanal-MOS-Transistors 3 (Knotenpunkt A) einen Zweipol 12 vorzusehen. Dieser Zweipol 12 besteht - von der Betriebsspannung 9 aus betrachtet - aus einer Reihenschaltung eines n-Kanal-JFET und eines p-Kanal-MOS-Depletion-Transistors, wobei das Gate des n-Kanal-JFET an den Knotenpunkt A und das Gate des p-Kanal-MOS-Depletion-Transistors an die Betriebsspannung 9 angeschlossen sind. Dieser Zweipol 12 weist eine Kennlinie mit einem teilweise negativen Verlauf auf (λ-Kennlinie).

Die Anordnung zeigt bei kleinen angelegten Spannungen (∼ < 1 Volt) einen kleinen Widerstand und bei Spannungen; die größer als die Summe aus Schwellspannung und Pinch-offSpannung sind, einen sehr großen Widerstand.

Dynamisch bewirkt der Zweipol 12, daß im Eingangs-L-Zustand diese Anordnung 12 leitend ist und den Basisstrom für den Bipolar-Transistor 6 vergrößert, so daß die parasitäre Kapazität am Ausgang 10 schneller aufgeladen wird. Ist die parasitäre Kapazität aufgeladen, so bleibt der Zweipol 12 auch weiterhin niederohmig.

Wird der Eingang von L auf H umgeschaltet, so ändern sich die Verhältnisse wie in Fig.1 beschrieben. Zusätzlich kommt nun aber noch ein Stromanteil vom Zweipol 12 hinzu, der über den n-Kanal-MOS-Transistor 2 in die Basis des Bipolar-Transistors 5 hineinfließt und diesen durchsteuert und damit die parasitäre Kapazität am Ausgang schneller und tiefer entlädt. Dieser Strom durch den Zweipol 12 fließt nur während der Umschaltphase. Ist das Potential am Knotenpunkt A auf einen Wert von etwa 1 V abgesunken, so ist der Zweipol 12 gesperrt und durch ihn fließt kein Strom mehr.

Weiterhin ist es möglich, einen weiteren Zweipol 13 zwischen der Betriebsspannung 9 und dem Ausgang 10 anzuordnen.

Dynamisch bewirkt der Zweipol 13, daß die Spannung am Ausgang 10 im H-Zustand des Ausganges 10 auf das Potential der Betriebsspannung 9 gezogen wird. Ohne den Zweipol 13 wird die Spannung am Ausgang 10 gegenüber der Betriebsspannung 9 um den Wert der UBE-Spannung abgesenkt.

Im L-Zustand am Ausgang 10 ist dann der Zweipol 13 gesperrt, so daß kein Ruhestrom fließen kann.

Um den Ausgangs-L-Pegel auf nahezu Massepotential herunterziehen zu können und um einen gegebenenfalls auftretenden Gleichstrom am Ausgang steuern zu können, ist ein weiterer Zweipol 14 zwischen dem Ausgang 10 und Masse 11 vorgesehen. Dieser Zweipol 14 ist im Ausgangs-L-Zustand sehr niederohmig und im Ausgangs-H-Zustand sehr hochohmig.

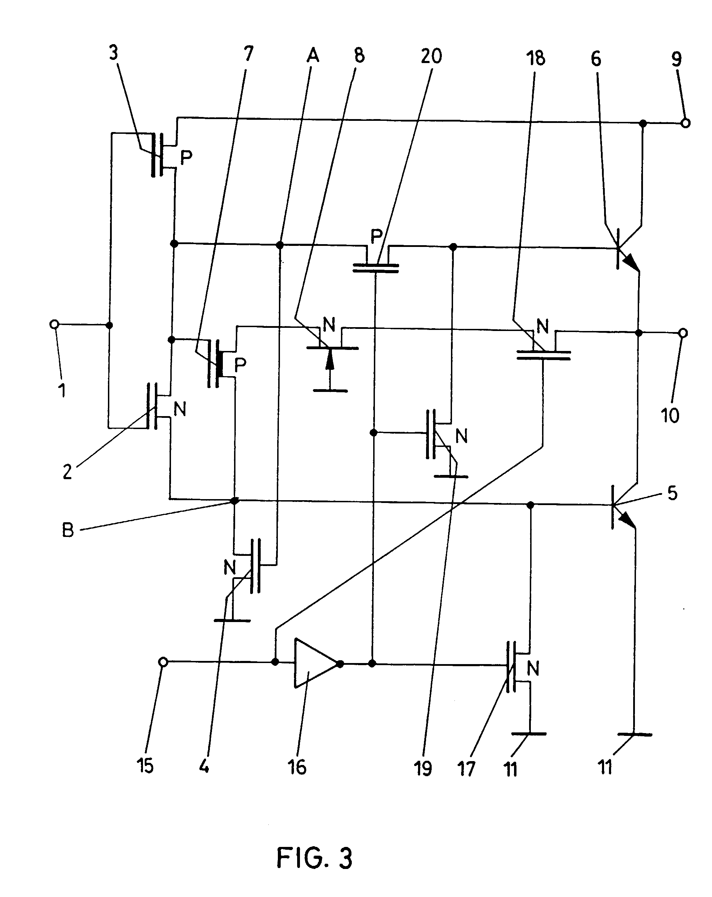

Gemäß Fig.3 kann die Schaltungsanordnung nach Fig.1 durch zusätzliche MOS-Transistoren zu einer TRISTATE-Schaltungsanordnung erweitert werden. Es ist ein weiterer Steuereingang 15 vorgesehen. Dieser Steuereingang 15 ist auf einen Negator 16 und auf das Gate eines n-Kanal-MOS-Transistors 18 geführt. Der Ausgang des Negators 16 ist mit den Gates von n-Kanal-MOS-Transistoren 17, 19 und mit dem Gate eines p-Kanal-MOS-Transistors 20 zusammengeschaltet. Die Source-Drain-Strecke des n-Kanal-MOS-Transistors 17 ist zwischen der Basis des Bipolar-Transistors 5 und Masse 11 angeordnet. Die Source-Drain-Strecke des n-Kanal-MOS-Transistors 18 ist zwischen dem Ausgang 10 und dem Drain des JFET 8 angeordnet. Die Source-Drain-Strecke des n-Kanal-MOS-Transistors 19 ist zwischen der Basis des Bipolar-Transistors 6 und Masse 11 vorgesehen, und schließlich ist die Source-Drain-Strecke des p-Kanal-MOS-Transistors 20 zwischen der Basis des Bipolar-Transistors 6 und dem Drain des p-Kanal-MOS-Transistors 3 angeordnet.

Der Steuereingang 15 mit den zusätzlichen MOS-Transistoren bewirkt nun, daß bei L-Pegel am Steuereingang 15 am Ausgang des Negators 16 der H-Pegel anliegt. Damit sind die n-Kanal-MOS-Transistoren 17 und 19 voll leitend und bewirken beim Bipolar-Transistor 5 einen Basis-Emitter-Kurzschluß und beim Bipolar-Transistor 6 ein Herunterziehen des Basispotentials auf Massepotential. Beide Bipolar-Transistoren sind damit sicher gesperrt, da auch der p-Kanal-MOS-Transistor 20 hochohmig ist.

Der n-Kanal-MOS-Transistor 18 ist auch gesperrt, da das Gate dieses Transistors L-Potential aufweist. Damit ist der Ausgang 10 hochohmig, gleichgültig, ob am Eingang 1 der H- oder L-Pegel anliegt.

Liegt dagegen am Steuereingang 15 der H-Pegel an, so ist der n-Kanal-MOS-Transistor 18 voll durchgesteuert und ist quasi als leitender Pass-Gate-Transistor zu betrachten. Damit sind die n-Kanal-MOS-Transistoren 17 und 19 gesperrt und beeinflussen die Schaltung nicht. Der p-Kanal-MOS-Transistor 20 ist nun ebenfalls leitend, da sein Gate den L-Pegel aufweist. Dieser Transistor wirkt ebenfalls wie ein Pass-Gate-Transistor. Die Schaltungsanordnung reagiert nun auf Eingangssignale so wie ein Negator, als wären diese Transistoren nicht vorhanden.

Auch bei dieser TRISTATE-Schaltungsanordnung kann der Zweipol 12 zwischen der Betriebsspannung 9 und dem Drain des p-Kanal-MOS-Transistors 3 vorgesehen werden, um die dynamischen Eigenschaften zu verbessern.

Weitere Eingänge können ebenfalls vorgesehen werden, um logische Verknüpfungsschaltungen zu realisieren.

## Patentansprüche

1. Integrierte Schaltungsanordnung mit Junction-, MOS- und Bipolar-Transistoren zur Realisierung von logischen Funktionen mit komplementären MOS-Transistoren, die von einem Eingang (1) gesteuert werden, und einer Reihenschaltung eines ersten und eines zweiten Bipolar-Transistors (5,6), die einen Ausgang steuert, wobei ein p-Kanal-MOS-Enhancement-Transistor (3) zwischen dem Kollektor und der Basis des zweiten Bipolar-Transistors (6) angeordnet ist, und der Eingang (1) auf die Gates von einem n-Kanal- und dem p-Kanal-MOS-Enhancement-Transistor (2, 3) gefürht ist, wobei das Source des n-Kanal-MOS-Enhancement-Transistors (2) mit der Basis des ersten Bipolar-Transistors (5) verbunden ist, dadurch gekennzeichnet daß das Drain des n-Kanal-MOS-Enhancement-Transistors (2) mit dem Drain des p-Kanal-MOS-Enhancement-Transistors (3), dem Gate eines zweiten n-Kanal-MOS-Transistors (4) und dem Gate eines p-Kanal-MOS-Depletion-Transistors (7) zusammengeschaltet ist, daß das Source des p-Kanal-MOS-Enhancement-Transistors (3) und der Kollektor des zweiten Bipolar-Transistors (6) mit der Betriebsspannung (9) verbunden sind, daß der Emitter des zweiten Bipolar-Transistors (6) und der Kollektor des ersten Bipolar-Transistors (5) mit dem Ausgang (10) zusammengeschaltet sind, daß das Drain des zweiten n-Kanal-MOS-Transistors (4) mit der Basis des ersten Bipolar-Transistors (5) verbunden ist, daß das Source des zweiten n-Kanal-MOS-Transistors (4) und der Emitter des ersten Bipolar-Transistors (5) mit Masse (11) zusammengeschaltet sind und daß zwischen dem Ausgang (10) und der Basis des ersten Bipolar-Transistors (5) eine Reihenschaltung eines n-Kanal-JFET (8) und des p-Kanal-MOS-Depletion-Transistors (7) angeordnet ist, wobei das Gate des n-Kanal-JFET (8) an Masse (11) oder am Drain des p-Kanal-MOS-Depletion-Transistors (7) angeschaltet ist.

2. Integrierte Schaltungsanordnung nach Anspruch 1, dadurch gekennzeichnet, daß zwischen der Betriebsspannung (9) und dem Drain des p-Kanal-MOS-Enhancement-Transistors (3) ein Zweipol (12), bestehend aus einer Reihenschaltung eines n-Kanal-JFET und eines p-Kanal-MOS-Depletion-Transistors, wobei das Gate des n-Kanal-JFET mit dem Drain des p-Kanal-MOS-Depletion-Transistors und das Gate des p-Kanal-MOS-Depletion-Transistors mit dem Drain des n-Kanal-JFET zusammengeschaltet sind, angeordnet ist.

3. Integrierte Schaltungsanordnung nach Anspruch 1 oder 2, dadurch gekennzeichnet, daß zwischen der Betriebsspannung (9) und dem Ausgang (10) ein Zweipol (13), bestehend aus einer Reihenschaltung eines n-Kanal-JFET und eines p-Kanal-MOS-Depletion -Transistors, wobei das Gate des n-Kanal-JFET mit dem Drain des p-Kanal-MOS-Depletion-Transistors und das Gate des p-Kanal-MOS-Depletion-Transistors mit dem Drain des n-Kanal-JFET zusammengeschaltet sind, angeordnet ist.

4. Integrierte Schaltungsanordnung nach einem der Ansprüche 1 bis 3, dadurch gekennzeichnet, daß zwischen dem Ausgang (10) und Masse (11) ein Zweipol (14), bestehend aus einer Reihenschaltung eines n-Kanal-JFET und eines p-Kanal-MOS-Depletion-Transistors, wobei das Gate des n-Kanal-JFET mit dem Drain des p-Kanal-MOS-Depletion-Transistors und das Gate des p-Kanal-MOS -Depletion-Transistors mit dem Drain des n-Kanal-JFET zusammengeschaltet sind, angeordnet ist.

5. Integrierte Schaltungsanordnung nach einem der Ansprüche 1 bis 4, dadurch gekennzeichnet, daß ein weiterer Steuereingang (15) vorgesehen ist, daß der Steuereingang (15) auf einen Negator (16) und auf das Gate eines dritten n-Kanal-MOS-Transistors (18) geführt ist, daß der Ausgang des Negators (16) auf Gates von vierten und fünften n-Kanal-MOS-Transistoren (17,19) und auf das Gate eines weiteren p-Kanal-MOS-Transistors (20) geführt ist, daß die Source-Drainstrecke des vierten n-Kanal-MOS-Transistors (17) zwischen der Basis des ersten Bipolar-Transistors (5) und Masse (11) angeordnet ist, daß die Source-Drainstrecke des dritten n-Kanal-MOS-Transistors (18) zwischen dem Ausgang (10) und dem Drain des n-Kanal-JFET (8) angeordnet ist, daß die Source-Drainstrecke des fünften n-Kanal-MOS-Transistors (19) zwischen der Basis des zweiten Bipolar-Transistors (6) und Masse (11) angeordnet ist und daß die Source-Drainstrecke des weiteren p-Kanal-MOS-Transistors (20) zwischen der Basis des zweiten Bipolar-Transistors (6) und dem Drain des p-Kanal-MOS-Enhancement-Transistors (3) vorgesehen ist.

6. Integrierte Schaltungsanordnung nach einem der Ansprüche 1 bis 7, dadurch gekennzeichnet, daß zur Realisierung von NAND-Schaltungen weitere n-Kanal-MOS-Transistoren in Reihe zum n-Kanal-MOS-Enhancement-Transistor (2) und weitere p-Kanal-MOS-Transistoren parallel zum p-Kanal-MOS-Enhancement-Transistor (3) angeordnet sind.

7. Integrierte Schaltungsanordnung nach einem der Ansprüche 1 bis 8, dadurch gekennzeichnet, daß zur Realisierung von NOR-Schaltungen weitere n-Kanal-MOS-Transistoren parallel zum n-Kanal-MOS-Enhancement-Transistor (2) und weitere p-Kanal-Transistoren in Reitie zum p-Kanal-MOS-Enhancement-Transistor (3) angeordnet sind.

## Claims

1. An integrated circuit arrangement comprising junction, MOS and bipolar transistors for realizing logic functions with complementary MOS transistors controlled by an input (1) and a series connection of a first and a second bipolar transistor (5, 6), said series connection controlling an output, wherein a p channel MOS enhancement transistor (3) is arranged between the collector and the base of the second bipolar transistor (6) and the input (1) is connected to the gates of an n channel and the p channel MOS enhancement transistors (2, 3), the source of the n channel MOS enhancement transistor (2) being connected with the base of the first bipolar transistor (5), characterized in that the drain of the n channel MOS enhancement transistor (2) is connected with the drain of the p channel MOS enhancement transistor (3), the gate of a second n channel MOS transistor (4) and the gate of a p channel MOS depletion transistor (7), that the source of the p channel MOS enhancement transistor (3) and the collector of the second bipolar transistor (6) are connected with the operating voltage (9), that the emitter of the second bipolar transistor (6) and the collector of the first bipolar transistor (5) are interconnected with the output (10), that the drain of the second n channel MOS transistor (4) is connected with the base of the first bipolar transistor (5), that the source of the second n channel MOS transistor (4) and the emitter of the first bipolar transistor (5) are interconnected with mass (11) and that a series connection of an n channel JFET (8) and of the p channel MOS depletion transistor (7) is arranged between the output (10) and the base of the first bipolar transistor (5), the gate of the n channel JFET (8) being connected to mass (11) or the drain of the p channel MOS depletion transistor (7).

2. An integrated circuit arrangement according to claim 1, characterized in that a two-terminal network (12) comprised of a series connection of an n channel JFET and a p channel MOS depletion transistor is arranged between the operating voltage (9) and the drain of the p channel MOS enhancement transistor (3), the gate of the n channel JFET being connected with the drain of the p channel MOS depletion transistor and the gate of the p channel MOS depletion transistor being connected with the drain of the n channel JFET.

3. An integrated circuit arrangement according to claim 1 or 2, characterized in that a two-terminal network (13) comprised of a series connection of an n channel JFET and a p channel MOS depletion transistor is arranged between the operating voltage (9) and the output (10), the gate of the n channel JFET being connected with the drain of the p channel MOS depletion transistor and the gate of the p channel MOS depletion transistor being connected with the drain of the n channel JFET.

4. An integrated circuit arrangement according to any one of claims 1 to 3, characterized in that a two-terminal network (14) comprised of a series connection of an n channel JFET and a p channel MOS depletion transistor is arranged between the output (10) and mass (11), the gate of the n channel JFET being connected with the drain of the p channel MOS depletion transistor and the gate of the p channel MOS depletion transistor being connected with the drain of the n channel JFET.

5. An integrated circuit arrangement according to any one of claims 1 to 4, characterized in that a further control input (15) is provided, that the control input (15) is connected to a negator (16) and to the gate of a third n channel MOS transistor (18), that the output of the negator (16) is connected to gates of fourth and fifth n channel MOS transistors (17, 19) and to the gate of a further p channel MOS transistor (20), that the source-drain spacing of the fourth n channel MOS transistor (17) is located between the base of the first bipolar transistor (5) and mass (11), that the source-drain spacing of the third n channel MOS transistor (18) is located between the output (10) and the drain of the n channel JFET (8), that the source-drain spacing of the fifth n channel MOS transistor (19) is located between the base of the second bipolar transistor (6) and mass (11) and that the source-drain spacing of the further p channel MOS transistor (20) is located between the base of the second bipolar transistor (6) and the drain of the p channel MOS enhancement transistor (3).

6. An integrated circuit arrangement according to any one of claims 1 to 7, characterized in that, for realizing NAND-circuits, further n channel MOS transistors are arranged in series with the n channel MOS enhancement transistor (2) and further p channel MOS transistors are arranged in parallel with the p channel MOS enhancement transistor (3).

7. An integrated circuit arrangement according to any one of claims 1 to 8, characterized in that, for realizing NOR-circuits, further n channel MOS transistors are arranged in parallel with the n channel MOS enhancement transistor (2) and further p channel transistors are arranged in series with the p channel MOS enhancement transistor (3).

## Revendications

1. Circuit intégré comportant des transistors à jonction, MOS et bipolaires pour la réalisation de fonctions logiques, comportant des transistors MOS complémentaires lesquels sont pilotés par une entrée, ainsi qu'un montage en série d'un premier et d'un deuxième transistors bipolaires (5, 6) qui pilote une sortie, tandis qu'un transistor MOS à enrichissement à canal P (3) est disposé entre le collecteur et la base du deuxième transistor bipolaire (6) et que l'entrée (1) est conduite aux grilles d'un transistor à canal N (2) et du transistor MOS à enrichissement à canal P (3), la source du transistor MOS à enrichissement à canal N (2) étant reliée à la base du premier transistor bipolaire (5), caractérisé en ce que le drain du transistor MOS à enrichissement à canal N (2) est interconnecté avec le drain du transistor MOS à enrichissement à canal P (3), avec la grille d'un deuxième transistor MOS à enrichissement à canal N (4) et avec la grille d'un transistor MOS à déplétion à canal P (7), en ce que la source du transistor MOS à enrichissement à canal P (3) et le collecteur du deuxième transistor bipolaire (6) sont reliés à la tension de fonctionnement (9), en ce que l'émetteur du deuxième transistor bipolaire (6) et le collecteur du premier transistor bipolaire (5) sont interconnectés avec la sortie (10), en ce que le drain d'un deuxième transistor MOS à canal N (4) est relié à la base du premier transistor bipolaire (5), en ce que la source du deuxième transistor MOS à canal N (4) et l'émetteur du premier transistor bipolaire (5) sont interconnectés à la masse (11) et en ce que, entre la sortie (10) et la base du premier transistor (5), est disposé un montage en série d'un transistor de jonction à effet de champ à canal N (8) et du transistor MOS à déplétion à canal P (7), la grille du transistor de jonction à effet de champ à canal N (8) étant connectée à la masse (11) ou bien au drain du transistor MOS à déplétion à canal P (7).

2. Circuit intégré conforme à la revendication 1, caractérisé en ce que, entre la tension de fonctionnement (9) et le drain du transistor MOS à enrichissement à canal P (3) est disposé un bipôle (12) constitué d'un montage en série d'un transistor de jonction à effet de champ à canal N et d'un transistor MOS à déplétion à canal P, la grille du transistor de jonction à effet de champ à canal N étant interconnectée avec le drain du transistor MOS à déplétion à canal P et la grille du transistor MOS à déplétion à canal P étant interconnectée avec le transistor de jonction à effet de champ à canal N.

3. Circuit intégré selon la revendication 1 ou 2, caractérisé en ce qu'entre la tension de fonctionnement (9) et la sortie (10) est disposé un bipôle (13) constitué d'un montage en série d'un transistor de jonction à effet de champ à canal N et d'un transistor MOS à déplétion à canal N, la grille du transistor de jonction à effet de champ à canal N étant interconnectée avec le drain du transistor MOS à déplétion à canal P et la grille du transistor MOS à déplétion à canal P étant interconnectée avec le drain du transistor de jonction à effet de champ à canal N.

4. Circuit intégré selon l'une des revendications 1 à 3, caractérisé en ce qu'entre la sortie (10) et la masse (11) est disposé un bipôle (14) constitué d'un montage en série d'un transistor de jonction à effet de champ à canal N et d'un transistor MOS à déplétion à canal P, la grille du transistor de jonction à effet de champ à canal N étant interconnectée avec le drain du transistor MOS à déplétion à canal P et la grille du transistor MOS à déplétion à canal P étant interconnectée avec le drain du transistor de jonction à effet de champ à canal N.

5. Circuit selon l'une des revendications 1 à 4, caractérisé par la présence d'une entrée complémentaire de commande (15), en ce que l'entrée de commande (15) est conduite à un inverseur logique (16) et à la grille d'un troisième transistor MOS à canal N (18), en ce que la sortie de l'inverseur logique (16) est conduite à la grille d'un quatrième et d'un cinquième transistors MOS à canal N (17, 19) et à la grille d'un autre transistor MOS à canal P (20), en ce que le trajet source-drain du quatrième transistor MOS à canal N (17) est disposé entre la base du premier transistor bipolaire (5) et la masse (11), en ce que le trajet source-drain du troisième transistor MOS à canal N (18) est disposé entre la sortie (10) et le drain du transistor de jonction à effet de champ à canal N (8), en ce que le trajet source-drain du cinquième transistor MOS à canal N (19) est disposé entre la base du deuxième transistor bipolaire (6) et la masse (11) et en ce que le trajet source-drain du transistor complémentaire MOS à canal P (20) est prévu entre la base du deuxième transistor bipolaire (6) et le drain du transistor MOS à enrichissement à canal P (3).

6. Circuit intégré selon l'une des revendications 1 à 7, caractérisé en ce que, pour la réalisation de circuits NON-ET, d'autres transistors MOS à canal N sont montés en série avec le transistor MOS à enrichissement à canal N (2) et d'autres transistors MOS à canal P en parallèle avec le transistor MOS à enrichissement à canal P (3).

7. Circuit intégré selon l'une des revendications 1 à 8, caractérisé en ce qu'en vue de la réalisation de circuits NON-OU, d'autres transistors MOS à canal N sont montés en parallèle avec le transistor MOS à enrichissement à canal N (2) et d'autres transistors MOS à canal P sont montés en série avec le transistor MOS à enrichissement à canal P (3).
